# EUROPEAN PATENT APPLICATION

(11) **EP 1 500 939 A1**
(43) Date of publication of application: **26.01.2005**
(21) Application number: 04017129.0
(22) Date of filing: 20.07.2004
(51) Int. Cl.: G01R 13/02

(54) **Network analyzer with highly versatile display**

(30) Priority: 25.07.2003 IT MI20030355 U
(71) Applicant: Herholdt Controls S.R.L., 20132 Milano (IT)
(72) Inventor: Herholdt, Hans Albin, 20052 Monza (IT)
(74) Representative: Modiano, Guido, Dr.-Ing.

(57) **Abstract**

A network analyzer, comprising at least one display (1) adapted to visualize quantities related to the electric network to which the analyzer is connected and further comprising cursor keys (2,3) adapted to allow "navigation" within the display (1) so as to assign parts thereof, of interest to the user, to the visualization of electrical quantities selected by the user among the quantities that can be measured by the instrument.

## Description

The present invention relates to a network analyzer with highly versatile display. More particularly, the invention relates to a network analyzer with a display that allows to achieve maximum flexibility in selecting the quantities to be displayed and in consequently displaying their values.

As is known, three-phase network analyzers are currently commercially available which are capable of measuring tens of electrical quantities related to the network to which they are connected. These instruments are conveniently provided with at least one display, in which the digits are provided by means of various technologies: LED arrays, liquid crystals (LCD), segment LEDs, fluorescence, et cetera.

Two different methods of presenting electrical measurements can be distinguished.

A first method uses predefined "pages", i.e., presents a preset and non-modifiable set of measurements and of any other indications, on the display or displays of the instrument. The available pages are scrolled, usually by pressing an appropriately provided key, to allow the user to view measurements that are not present in the preceding "pages".

However, the solution described above, currently adopted for instruments that measure tens of quantities, makes the system rigid, in that the user has no possibility to change the order of presentation of the pages or to change their content or shift the visualization of the quantities within the display or displays.

This means that if the user wishes to see the value of a quantity that is for example in the last of the display pages, he is forced to scroll all the pages that are present until he reaches the intended one.

This leads to an assured waste of time and to complexity in reading the display, which entails the need to have a bulky instructions manual to use the instrument as an accessory of the network analyzer.

A second method of presenting data is provided on three-phase instruments, which typically have three displays (or a single liquid-crystal display), which provide, as a default, the indication of the values of a preset three-phase electrical quantity (or, as an alternative, the last quantity selected by the operator).

These instruments have at least one key for selecting the electrical quantities, to be selected in various manners, a typical one being the sequential one, among the quantities given in the form of abbreviations and symbols on the front of the device or in an appropriately provided area of the LCD display.

Selection is performed by the user usually by employing the feedback provided by indicator lights or other luminous indicators. An indicator light that is lit at the symbol of a quantity indicates that the values displayed at that moment on the displays refer to that quantity.

Some instruments provide the operator with two keys instead of one, in order to allow scrolling in two opposite directions of the sequence of quantities and thus reduce the time required to search for the intended quantity.

The second method described above is certainly more flexible than the first one, although it does not allow to have the maximum possible flexibility in selecting the quantities to be displayed and in consequently visualizing their values, but in practice is necessarily applicable to instruments that measure a limited number of quantities.

The aim of the present invention is to provide a network analyzer with highly flexible display that allows the user to select the quantities to be visualized and the displays by means of which they are to be visualized, without having to perform complicated operations.

Within this aim, an object of the present invention is to provide a network analyzer with highly flexible display that entails a much smaller instructions manual than that of conventional similar devices.

This aim and these and other objects that will become better apparent hereinafter are achieved by a network analyzer, comprising at least one display adapted to visualize quantities related to the electric network to which said analyzer is connected, characterized in that it comprises cursor keys adapted to allow "navigation" within said display so as to assign parts thereof, at the user's discretion, for the visualization of certain electrical quantities selected by the user among the quantities that can be measured by the instrument.

Further characteristics and advantages of the invention will become better apparent from the description of the network analyzer according to the present invention, illustrated by way of nonlimiting example in the accompanying drawings, wherein:

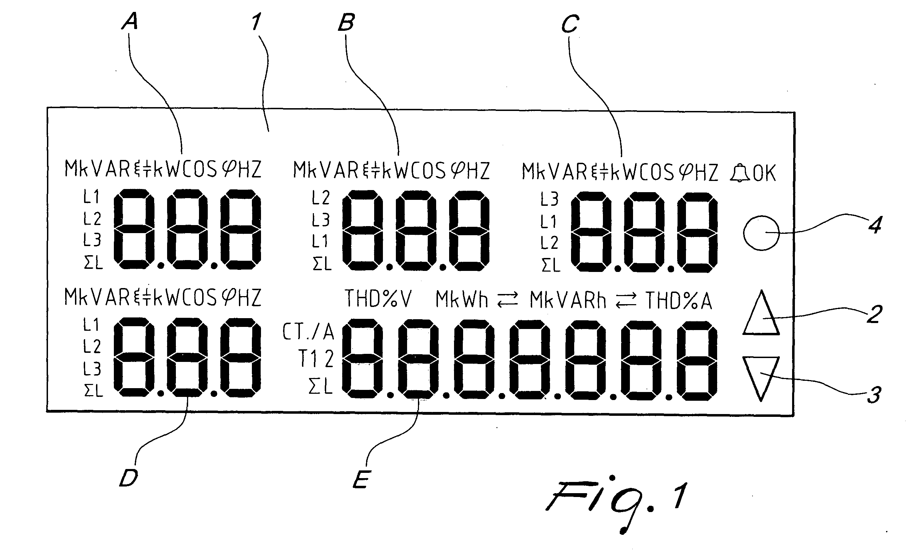

Figure 1 is a schematic view of the display of the network analyzer according to the present invention; and
Figure 2 is a schematic view of the display of Figure 1, in a functional example.

With reference to the figures, the network analyzer according to the invention is provided with at least one display 1, which is configured so as to combine in a single view all the symbols and units of measure of the electrical quantities that can be measured by the analyzer. In particular, the figure shows, merely by way of example, the presence of five distinct visualization units combined in the single display 1.

By way of cursor keys 2 and 3 and a confirmation key 4, provided on the front panel of the network analyzer, next to the display 1, it is possible to "navigate" within the display by selecting first the portion of display of interest and then the electrical quantity to be displayed in said portion of display. The electrical quantities and the units of measure are made to flash sequentially by means of the cursor keys and are then confirmed by means of the appropriately provided key.

In this manner, by very simple operations, the user is capable of visualizing the plurality of quantities of interest in the display portions of interest.

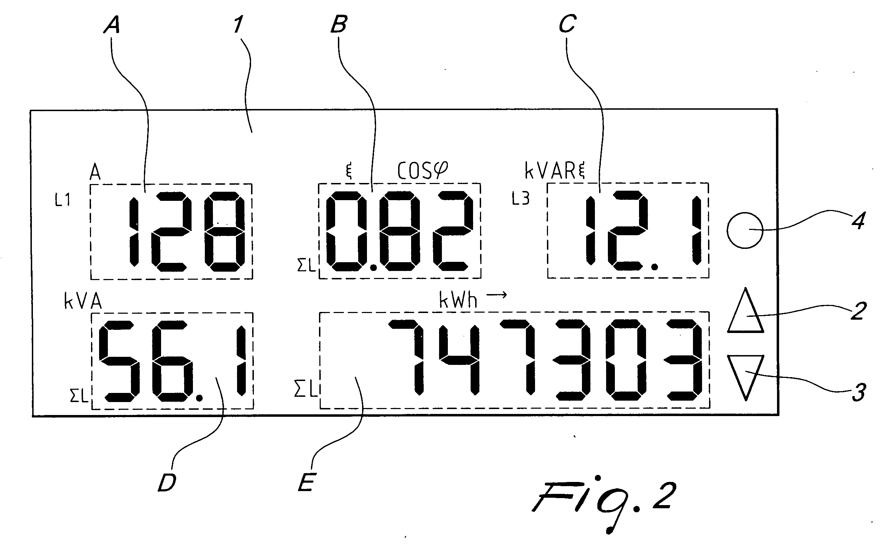

The exemplifying Figure 2 shows: in the display portion A, the phase current of the phase 1 in amps; in the display portion B, the power factor of the three-phase inductive load; in the display portion C, the reactive (inductive) power of the phase 3; in the display portion D, the apparent instantaneous power of the three-phase load; in the display portion E, the active energy absorbed by the three-phase load starting from when the counter is reset; however, the operator could have swapped, at his discretion, for example, the visualization of the portions A and D of the display.

In the practical embodiment provided, shown in Figure 2, it is not possible to swap the visualization of the portion E of the display with that of the other portions, due to the disparity of digits thereof, but evidently there is no conceptual hindrance to the possibility of providing the conditions to allow the swap.

The solution described above allows to reduce to a minimum the instructions manual, which can be substantially reduced to a small number of simple operating instructions regarding the use of the two cursor keys 2 and 3 and of the confirmation key 4, since "navigation" within the display, in its various subregions, is similar for every portion of the display.

In practice it has been found that the device according to the invention achieves the intended aim and objects, since it allows to visualize, at the full discretion of the user, different electrical quantities, all by selecting, by way of cursor keys, the portions of display and the quantities to be displayed therein.

All the details may further be replaced with other technically equivalent elements.

The disclosures in Italian Utility Model Application No. MI2003U000355 from which this application claims priority are incorporated herein by reference.

Where technical features mentioned in any claim are followed by reference signs, those reference signs have been included for the sole purpose of increasing the intelligibility of the claims and accordingly, such reference signs do not have any limiting effect on the interpretation of each element identified by way of example by such reference signs.

## Claims

1. A network analyzer, comprising at least one display (1) adapted to visualize quantities related to the electric network to which said analyzer is connected, **characterized in that** it comprises cursor keys (2,3) adapted to allow "navigation" within said display so as to select portions of said display (1) for the visualization of electrical quantities.

2. The device according to claim 1, **characterized in that** said cursor keys (2,3) comprise a first cursor key (2) and a second cursor key (3), which are adapted to allow complete "navigation" within said display (1), and a key (4) for confirming the selected quantity.

3. The device according to claim 2, **characterized in that** said confirmation key (4) enables the selection made by way of said cursor keys (2,3).
